# EUROPÄISCHE PATENTSCHRIFT

(11) **EP 1 120 660 B1**
(45) Veröffentlichungstag und Bekanntmachung des Hinweises auf die Patenterteilung: **23.03.2005**
(21) Anmeldenummer: 01100375.3
(22) Anmeldetag: 05.01.2001
(51) Int. Cl.: G01R 29/26, G01R 19/165, H03K 5/08

(54) **Vorrichtung und Verfahren zur Auswertung von offsetspannungsbehafteten digitalen Signalen**
Apparatus and method for evaluating offset voltages of digital signals
Appareil et procédé pour évaluer des tensions de décalage dans des signaux numériques

(30) Priorität: 18.01.2000 DE 10001849
(43) Veröffentlichungstag der Anmeldung: 01.08.2001
(73) Patentinhaber: SIEMENS AKTIENGESELLSCHAFT, 80333 München (DE)
(72) Erfinder: Munz, Dieter, Dipl.-Ing., 91315 Höchstadt (DE)

(56) Entgegenhaltungen:
- EP-A- 0 252 609
- EP-A- 0 371 400
- EP-A- 0 621 460
- US-A- 4 075 507
- US-A- 4 254 469
- US-A- 4 821 292

## Beschreibung

Die Erfindung betrifft eine Vorrichtung und ein Verfahren zur Auswertung von offsetspannungsbehafteten digitalen Signalen.

Eine Auswertung von offsetspannungsbehafteten digitalen Signalen wird durch eine unerwünschte Veränderung der Offsetspannung während des Betriebes erschwert. Derartige unerwünschte Veränderungen der Offsetspannung können beispielsweise durch Temperatureinflüsse und durch eine Alterung von Bauteilen im Signalweg des digitalen Signals verursacht werden.

Um den Einfluss derartiger unerwünschter Veränderungen der Offsetspannung bei der Auswertung offsetspannungsbehafteter digitaler Signale zu eliminieren, wurden bereits flankensensitive Auswerteschaltungen vorgeschlagen. Bei diesen Schaltungen wird die Offsetspannung entweder durch eine Kondensatorankopplung oder durch eine Differenzierung des Eingangssignals unter Verwendung von unterschiedlichen Laufzeitgliedern eliminiert. Wechselspannungsgekoppelte Auswerteschaltungen setzen das Vorliegen einer gleichstromfreien Signalcodierung voraus, beispielsweise einer Manchester-Codierung oder einer 4B/5B-Codierung. Bei Auswerteschaltungen, die mit einer Differenzierung des offsetbehafteten digitalen Eingangssignals arbeiten, wird nach dem Vorliegen längerer Sendepausen das erste ankommende Bit verzerrt bzw. verkürzt ausgegeben. Ferner benötigen die vorgenannten Auswerteschaltungen für die Rückgewinnung des digitalen Signals einen Speicher. Eventuelle kurzzeitige Störungen, welche die flankensensitive Auswertung beeinflussen, werden bis zum nächsten Signalflankenwechsel gespeichert. Dies führt dazu, daß am Ausgang der Auswerteschaltung bis zum nächsten Flankenwechsel ein falsches Signal ausgegeben bzw. das Störungssignal verlängert wird.

Aus EP 0 621 460 ist eine Sensorsignalverarbeitungseinheit bekannt, mit einer ersten Halteeinrichtung zum Halten eines Spitzenwerts eines Ausgangssignals eines Sensors sowie mit einer zweiten Halteeinrichtung zum Halten eines Tiefstwerts des Ausgangssignals des Sensors. Die Signalverarbeitungseinheit weist darüber hinaus eine Schwellwerteinstellvorrichtung zum Einstellen eines Schwellwertes sowie eine Vergleichseinrichtung zum Vergleichen des jeweiligen Ausgangssignals des Sensors mit dem jeweiligen Schwellwert und zum Ausgeben eines binären Ausgangssignals entsprechend dem Vergleichsergebnis auf.

Ausgehend von diesem Stand der Technik liegt der Erfindung die Aufgabe zugrunde einen Weg aufzuzeigen, wie die vorstehend beschriebenen Nachteile bekannter Vorrichtungen vermieden werden können.

Diese Aufgabe wird durch eine Vorrichtung mit den im Anspruch 1 angegebenen Merkmalen gelöst. Vorteilhafte Ausgestaltungen und Weiterbildungen der Erfindung sind in den abhängigen Ansprüchen angegeben. Der Anspruch 11 betrifft ein Verfahren zur Auswertung von offsetspannungsbehafteten digitalen Signalen.

Die Vorteile der Erfindung bestehen insbesondere darin, daß durch die automatische Anpassung der Ansprechschwelle des Komparators der Auswerteschaltung an die jeweils vorliegende Offsetspannung der Einfluß der Offsetspannung auf die Auswertung der offsetspannungsbehafteten digitalen Signale eliminiert wird. Die Erfindung ist unabhängig von der Signalcodierung der empfangenen digitalen Signale. Sie erlaubt auch eine Auswertung hochfrequenter digitaler Signalfolgen mit nicht gleichstromfreier Codierung, beispielsweise einer NRZ-Codierung. Weitere Vorteile der Erfindung bestehen in der Reduzierung des Einflusses von externen Störsignalen auf die Auswerteschaltung. Da bei der beanspruchten pegelsensitiven Auswertung das Ausgangssignal nicht gespeichert wird, werden Störsignale nur maximal solange ausgegeben, wie sie auf die Schaltung einwirken.

Weitere vorteilhafte Eigenschaften der Erfindung ergeben sich aus der Erläuterung von Ausführungsbeispielen anhand der Figuren. Es zeigen:
- FIG 1: ein Ausführungsbeispiel für ein offsetspannungsbehaftetes digitales Signal,
- FIG 2: ein Schaltbild einer ersten Vorrichtung zur Auswertung von digitalen Signalen und
- FIG 3: ein Schaltbild einer zweiten Vorrichutng zur Auswertung von digitalen Signalen.

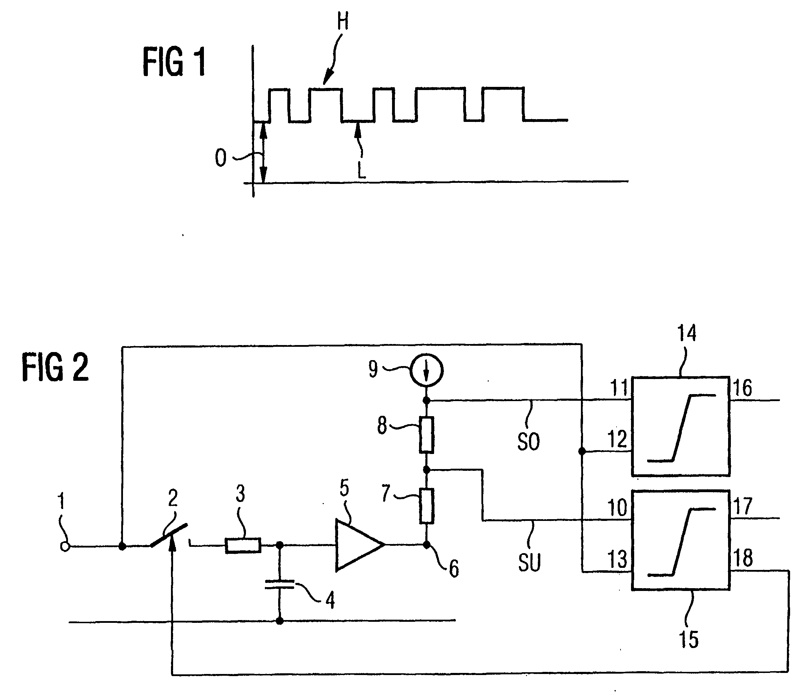

Die einer Auswerteschaltung zugeführten digitalen Signale können mit einer Offsetspannung beaufschlagt sein, die im Betrieb unerwünschten Änderungen unterliegt. Diese Änderungen können auf Temperatureinflüsse und auf eine Alterung von Bauteilen, die im Signalweg des digitalen Signals liegen, zurückzuführen sein. Ein Ausführungsbeispiel für ein derartiges offsetspannungsbehaftetes digitales Signal ist in der Figur 1 gezeigt. Das gezeigte digitale Signal, welches mit einer beliebigen Codierung versehen ist, weist HIGH-Pegel H und LOW-Pegel L auf, die jeweils von einer Offsetspannung O überlagert sind.

Ein derartiges offsetspannungsbehaftetes digitales Signal wird dem Eingang 1 der in der Figur 2 dargestellten Vorrichtung zugeführt.

Der Eingang 1 der gezeigten Vorrichtung ist mit dem Eingang eines Schalters 2 verbunden. Weiterhin wird das am Eingang 1 anliegende Eingangssignal dem Eingang 12 eines zweiten Komparators 14 und dem Eingang 13 eines ersten Komparators 15 zugeführt.

Der Ausgang des Schalters 2 ist über einen Widerstand 3 mit einem ersten Anschluß eines als Speicher dienenden Kondensators 4 und mit dem Eingang eines Verstärkers 5 verbunden. Der zweite Anschluß des Kondensators 4 liegt auf einem Bezugspotential, beispielsweise Masse.

Am Ausgang des Verstärkers 5 befindet sich der Fußpunkt 6 einer Schaltung zur Einstellung eines ersten Schwellenwertes SU und eines zweiten Schwellenwertes SO. Diese Schaltung weist eine Konstantstromquelle 9 und eine zwischen der Konstantstromquelle und dem Fußpunkt 6 angeordnete Reihenschaltung aus zwei Ohmschen Widerständen 7 und 8 auf. Am Verbindungspunkt zwischen der Konstantstromquelle 9 und dem Widerstand 8 liegt der zweite Schwellenwert SO vor. Dieser wird einem Eingang 11 des zweiten Komparators 14 zugeführt. Zwischen den beiden Widerständen 7 und 8 ist der erste Schwellenwert SU abgreifbar, welcher dem Eingang 10 des ersten Komparators 15 zugeleitet ist. Der zweite Schwellenwert ist dabei größer als der erste Schwellenwert.

Im zweiten Komparator 14 erfolgt ein Vergleich des zweiten Schwellenwertes SO mit dem am Eingang 1 anliegenden offsetspannungsbehafteten digitalen Signal. Ist letzeres kleiner als der zweite Schwellenwert, dann wird am Ausgang 16 des zweiten Komparators 14 ein Meldesignal zur Verfügung gestellt. Dieses enthält eine Information dafür, daß der Pegel des übertragenen digitalen Signals aufgrund von Alterungseffekten von im Signalweg liegenden Bauteilen so stark abgesunken ist, daß eine Wartung der Vorrichtung bzw. ein Bauteilersatz notwendig ist.

Im ersten Komparator 15 erfolgt ein Vergleich des ersten Schwellenwertes SU mit dem am Eingang 1 anliegenden offsetspannunsbehafteten digitalen Signal. Ist letzteres kleiner als der erste Schwellenwert, dann wird am Ausgang 17 des ersten Komparators 15 ein offsetspannungsfreies LOW-Pegel-Signal zur Verfügung gestellt. Ist es hingegen größer als der erste Schwellenwert, dann wird am Ausgang 17 des ersten Komparators 14 ein offsetspannungsfreies HIGH-Pegel-Signal zur Verfügung gestellt.

Der erste Komparator 15 weist einen weiteren Ausgang 18 auf. An diesem wird stets dann, wenn am Ausgang 17 des ersten Komparators 15 ein offsetspannungsfreies LOW-Pegel-Signal vorliegt, ein Steuersignal für den Schalter 2 ausgegeben, welches den Schalter 2 einschaltet, d.h. in den durchlässigen Zustand bringt.

Über diesen durchlässigen Schalter 2 und den Widerstand 3 gelangt das Eingangssignal, welches der Offsetspannung entspricht, an den Speicherkondensator 4, wo es abgespeichert wird. Nach dieser Abspeicherung steht die abgespeicherte Offsetspannung über den Verstärker 5 am Fußpunkt 6 zur Verfügung. Dort dient sie als analoger Bezugspunkt zur Einstellung der Schwellenwerte für die Komparatoren 14 und 15.

Demnach werden die Schwellenwerte für die Komparatoren 14 und 15 bei jedem Vorliegen eines LOW-Pegel-Signals in der offsetspannungsbehafteten digitalen Eingangssignalfolge an die momentan vorliegende Offsetspannung angepaßt. Dies erlaubt eine pegelsensitive Auswertung des empfangenen digitalen Signals ohne Verwendung einer Kondensatorankopplung und ohne Durchführung einer Differenzierung des Eingangssignals.

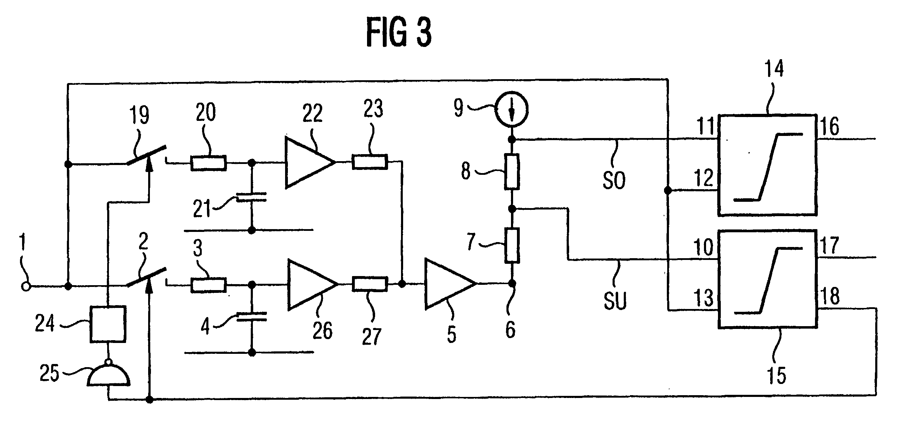

Die Figur 3 zeigt ein zweites Ausführungsbeispiel einer Vorrichtung zur Auswertung von offsetspannungsbehafteten digitalen Signalen. Diese Vorrichtung unterscheidet sich von der in der Figur 2 gezeigten Vorrichtung im wesentlichen dadurch, dass sie parallel zu dem Signalweg mit dem Schalter 2, dem Widerstand 3, dem Kondensator 4, einem Verstärker 26 und einem Widerstand 27 einen weiteren Signalweg mit einem Schalter 19, einem Widerstand 20, einem Speicher 21, einem Verstärker 22 und einem Widerstand 23 aufweist.

Der Zweck dieser Zusatzschaltung besteht darin, Signalverzerrungen zu verkleinern, die bei der Vorrichtung gemäß Figur 2 beim Vorliegen von Signalen mit langsam ansteigenden Flanken auftreten können.

Zu diesem Zweck sind die Zeitkonstanten der RC-Glieder 20/21 bzw. 3/4 unterschiedlich gewählt. Das RC-Glied 3/4 weist eine große Zeitkonstante von 1 ms auf. Das RC-Glied 20/21 hat eine kleine Zeitkonstante von 1 ns. Durch diese Wahl der Zeitkonstanten und die in der Figur 3 gezeigte Ansteuerung der Schalter 2 und 19 wird erreicht, daß sowohl eine Erfassung des LOW-Pegels bzw. der Offsetspannung als auch eine Erfassung des HIGH-Pegels des Eingangssignals erfolgt und die Ansprechschwellen der Komparatoren 14 und 15 auf die Mittenspannung bezogen werden, die am Verbindungspunkt zwischen den Widerständen 23 und 27 anliegt.

Bei der Realisierung der analogen Verstärker 22, 26 und 5 ist darauf zu achten, daß die Offsetspannung der Verstärker klein gegenüber dem Minimalwert des zu erfassenden digitalen Signals ist. Die Verstärker 22 und 5 müssen als schnelle Verstärker und die Komparatoren 14 und 15 als schnelle Komparatoren realisiert werden, da die Spannung am Kondensator 21 während der Dauer eines Bits den HIGH-Pegel des Signals erreichen muß. Zu berücksichtigen sind dabei die Signallaufzeit und die Einschaltdauer der Schalter 2 und 19. Weiterhin müssen auch die Leckströme (Offset- und Biasströme) beachtet werden. Diese dürfen die an den Kondensatoren 4 und 21 anliegende Spannung und auch die am Verbindungspunkt zwischen den Widerständen 23 und 27 anliegende Spannung nicht beeinflussen.

Mittels des Laufzeitgliedes 24 wird sichergestellt, daß die Einschaltdauer des Schalters 19 auf die Dauer eines Pegelzustandes beschränkt ist.

## Patentansprüche

1. Vorrichtung zur Auswertung von digitalen Signalen, mit
• einem Signaleingang (1),
• einem mit dem Signaleingang über einen Schalter (2) verbundenen Speicher (4),
• Mitteln (7, 8, 9) zur Einstellung eines ersten Schwellenwertes (SU) und
• einem ersten Komparator (15) zum Vergleichen des Eingangssignals mit dem ersten Schwellenwert, um beim Vorliegen eines Eingangssignals, welches größer ist als der erste Schwellenwert, ausgangsseitig ein HIGH-Pegel-Signal und beim Vorliegen eines Eingangssignals, welches kleiner ist als der erste Schwellenwert, ausgangsseitig ein LOW-Pegel-Signal zur Verfügung zu stellen, wobei der erste Komparator (15) einen Ausgang (18) aufweist, an welchem beim Vorliegen eines Eingangssignals, welches kleiner ist als der erste Schwellenwert, ein den Schalter (2) schließendes Steuersignal bereitgestellt wird,
**dadurch gekennzeichnet,**
**dass** die Mittel zur Einstellung der Schwellenwerte eine Konstantstromquelle (9) und eine mit der Konstantstromquelle verbundene Reihenschaltung aus zwei Widerständen (7, 8) enthalten und dass der von der Konstantstromquelle (9) abgelegene Anschluss der Reihenschaltung der Widerstände (7, 8) einen Fußpunkt (6) bildet und der Speicher (4) mit diesem Fußpunkt (6) über einen Verstärker (5) verbunden ist.

2. Vorrichtung nach Anspruch 1,
**dadurch gekennzeichnet,**
**dass** sie einen zweiten Komparator (14) enthält, welcher einen ersten Eingang (11) für einen zweiten Schwellenwert (SO), der größer ist als der erste Schwellenwert, einen mit dem Signaleingang (1) verbundenen zweiten Eingang (12) und einen Ausgang (16) aufweist, an welchem beim Vorliegen eines Eingangssignals, welches kleiner ist als der zweite Schwellenwert, ein Meldesignal ausgegeben wird.

3. Vorrichtung nach Anspruch 1 oder 2,
**dadurch gekennzeichnet,**
**dass** der Ausgang (18), an dem das Steuersignal für den Schalter (2) anliegt, ein weiterer Ausgang des ersten Komparators (15) ist.

4. Vorrichtung nach einem der vorhergehenden Ansprüche,
**dadurch gekennzeichnet,**
**dass** der zweite Schwellenwert zwischen der Konstantstromquelle (9) und dem mit der Konstantstromquelle verbundenen ersten Widerstand (8) der Reihenschaltung abgreifbar ist.

5. Vorrichtung nach einem der vorhergehenden Ansprüche,
**dadurch gekennzeichnet,**
**dass** der erste Schwellenwert zwischen den beiden Widerständen (7, 8) der Reihenschaltung abgreifbar ist.

6. Vorrichtung nach einem der vorhergehenden Ansprüche,
**dadurch gekennzeichnet,**
**dass** der Fußpunkt (6) mit dem Speicher (4) über einen Verstärker (5) verbunden ist.

7. Vorrichtung nach einem der vorhergehenden Ansprüche,
**dadurch gekennzeichnet,**
**dass** der Schalter (2) mit dem Speicher (4) über einen Widerstand (3) verbunden ist.

8. Vorrichtung nach einem der vorhergehenden Ansprüche,
**dadurch gekennzeichnet,**
**dass** der Speicher (4) ein Kondensator ist, dessen einer Anschluss zwischen dem Widerstand (3) und dem Verstärker (5) angeordnet ist und dessen anderer Anschluss mit einem Bezugspotential verbunden ist.

9. Vorrichtung nach einem der vorhergehenden Ansprüche,
**dadurch gekennzeichnet,**
**dass** sie zwischen dem Signaleingang (1) und dem Fußpunkt (6) eine Parallelschaltung zweier Signalwege aufweist, die jeweils einen Schalter und ein RC-Glied enthalten, wobei die Zeitkonstanten der beiden RC-Glieder sich voneinander unterscheiden.

10. Vorrichtung nach einem der vorhergehenden Ansprüche,
**dadurch gekennzeichnet,**
**dass** die Schalter jeweils mit demselben Ausgang (18) des ersten Komparators (15) verbunden sind, wobei zwischen dem Ausgang (18) des ersten Komparators (15) und dem Schalter (19) mit der kleineren Zeitkonstanten ein Inverter (25) und ein Zeitglied (24) vorgesehen sind.

11. Verfahren zur Auswertung von digitalen Signalen, bei welchem die digitalen Signale in einem Komparator (15) mit einem ersten Schwellenwert (SU) verglichen werden, am Ausgang des Komparators (15) LOW-Pegel-Signale oder HIGH-Pegel-Signale zur Verfügung gestellt werden und der Schwellenwert (SU) in Abhängigkeit von der den digitalen Signalen überlagerten Offsetspannung verändert wird, wobei die Offsetspannung während des Vorliegens eines LOW-Pegel-Signals erfaßt und als Referenzwert für die Einstellung des Schwellenwertes für die Komparatorschaltung in einem Speicher (4) gespeichert wird und wobei während des Vorliegens nachfolgender LOW-Pegel-Signale eine Aktualisierung der gespeicherten Offsetspannung erfolgt
**dadurch gekennzeichnet,**
**dass** die Schwellenwerte mittels einer Konstantstromquelle (9) und eine mit der Konstantstromquelle (9) verbundene Reihenschaltung aus zwei Widerständen (7, 8) eingestellt werden, wobei der von der Konstantstromquelle (9) abgelegene Anschluss der Reihenschaltung der Widerstände (7, 8) einen Fußpunkt (6) bildet und der Speicher (4) mit diesem Fußpunkt (6) über einen Verstärker (5) verbunden ist.

## Claims

1. Device for evaluating digital signals with
• a signal input (1),
• a storage unit (4) connected to the signal input via a switch (2),
• means (7, 8, 9) for adjusting a first threshold value (SU) and
• a first comparator (15) to compare the input signal with the first threshold value, in order to supply a HIGH level signal at the output in the presence of an input signal that is greater than the first threshold value and to supply a LOW level signal at the output in the presence of an input signal that is smaller than the first threshold value, with the first comparator (15) having an output (18), at which a control signal that closes the switch (2) is supplied in the presence of an input signal that is smaller than the first threshold value,
**characterized in that**
the means for adjusting the threshold values include a constant current source (9) and a series circuit comprising two resistors (7, 8) connected to the constant current source and that the terminal of the series circuit of the resistors (7, 8) provided by the constant current source (9) forms a base point (6) and the storage unit (4) is connected to this base point (6) via an amplifier (5).

2. Device according to Claim 1,
**characterized in that** it includes a second comparator (14), which has a first input (11) for a second threshold value (SO), which is greater than the first threshold value, a second input (12) connected to the signal input (1) and an output (16), at which a report signal is output in the presence of an input signal that is smaller than the second threshold value.

3. Device according to Claim 1 or 2,
**characterized in that** the output (18), at which the control signal for the switch (2) is present, is a further output of the first comparator (15).

4. Device according to one of the preceding Claims,
**characterized in that** the second threshold value can be picked up between the constant current source (9) and the first resistor (8) of the series circuit connected to the constant current source.

5. Device according to one of the preceding Claims,
**characterized in that** the first threshold value can be picked up between the two resistors (7, 8) of the series circuit.

6. Device according to one of the preceding Claims,
**characterized in that** the base point (6) is connected to the storage unit (4) via an amplifier (5).

7. Device according to one of the preceding Claims,
**characterized in that** the switch (2) is connected to the storage unit (4) via a resistor (3).

8. Device according to one of the preceding Claims,
**characterized in that** the storage unit (4) is a capacitor, the one terminal of which is arranged between the resistor (3) and the amplifier (5) and the other terminal of which is connected to a reference potential.

9. Device according to one of the preceding Claims,
**characterized in that** it has a parallel circuit of two signal paths between the signal input (1) and the base point (6), each of which signal paths includes a switch and an RC element, with the time constants of the two RC elements being different from each other.

10. Device according to one of the preceding Claims,
**characterized in that** the switches are each connected to the same output (18) of the first comparator (15), with an inverter (25) and a time element (24) being provided between the output (18) of the first comparator (15) and the switch (19) with the smaller time constant.

11. Method for evaluating digital signals, in which the digital signals are compared in a comparator (15) with a first threshold value (SU), LOW level signals or HIGH level signals are supplied at the output of the comparator (15) and the threshold value (SU) is modified as a function of the offset voltage overlaying the digital signals, with the offset voltage being detected during the presence of a LOW level signal and being stored in a storage unit (4) as a reference value for the adjustment of the threshold value for the comparator circuit and with the stored offset voltage being updated during the presence of subsequent LOW level signals,
**characterized in that** the threshold values are adjusted by means of a constant current source (9) and a series circuit comprising two resistors (7, 8) connected to the constant current source (9), with the terminal of the series circuit of the resistors (7, 8) provided by the constant current source (9) forming a base point (6) and the storage unit (4) being connected to this base point (6) via an amplifier (5).

## Revendications

1. Dispositif d'évaluation de signaux numériques, comportant :
• une entrée de signal (1),
• un dispositif de stockage (4) relié à l'entrée de signal par l'intermédiaire d'un interrupteur (2),
• des moyens (7, 8, 9) pour régler une première valeur de seuil (SU) et
• un premier comparateur (15) pour comparer le signal d'entrée à la première valeur de seuil pour, en présence d'un signal d'entrée supérieur à la première valeur de seuil, fournir en sortie un signal de niveau haut HIGH et, en présence d'un signal d'entrée inférieur à la première valeur de seuil, fournir en sortie un signal de niveau bas LOW, le premier comparateur (15) comportant une sortie (18) à laquelle, en présence d'un signal d'entrée inférieur à la première valeur de seuil, un signal de commande fermant l'interrupteur (2) est fourni,
**caractérisé par le fait que** les moyens de réglage des valeurs de seuil contiennent une source de courant constant (9) et un circuit série relié à la source de courant constant et composé de deux résistances (7, 8) et que la borne, à l'opposé de la source de courant constant (9), du circuit série composé des résistances (7, 8) forme une base (6) et que le dispositif de stockage (4) est relié à cette base (6) par l'intermédiaire d'un amplificateur (5).

2. Dispositif selon la revendication 1,
**caractérisé par le fait qu'**il contient un deuxième comparateur (14) qui comporte une première entrée (11) pour une deuxième valeur de seuil (SO) supérieure à la première valeur de seuil, une deuxième entrée (12) reliée à l'entrée de signal (1) et une sortie (16) à laquelle, en présence d'un signal d'entrée inférieur à la deuxième valeur de seuil, un signal d'avertissement est fourni.

3. Dispositif selon la revendication 1 ou 2,
**caractérisé par le fait que** la sortie (18) à laquelle se trouve le signal de commande pour l'interrupteur (2) est une autre sortie du premier comparateur (15).

4. Dispositif selon l'une des revendications précédentes,
**caractérisé par le fait que** la deuxième valeur de seuil peut être prélevée entre la source de courant constant (9) et la première résistance (8), reliée à la source de courant constant, du circuit série.

5. Dispositif selon l'une des revendications précédentes,
**caractérisé par le fait que** la première valeur de seuil peut être prélevée entre les deux résistances (7, 8) du circuit série.

6. Dispositif selon l'une des revendications précédentes,
**caractérisé par le fait que** la base (6) est reliée au dispositif de stockage (4) par l'intermédiaire d'un amplificateur (5).

7. Dispositif selon l'une des revendications précédentes,
**caractérisé par le fait que** l'interrupteur (2) est relié au dispositif de stockage (4) par l'intermédiaire d'une résistance (3).

8. Dispositif selon l'une des revendications précédentes,
**caractérisé par le fait que** le dispositif de stockage (4) est un condensateur dont une borne est placée entre la résistance (3) et l'amplificateur (5) et dont l'autre borne est reliée à un potentiel de référence.

9. Dispositif selon l'une des revendications précédentes,
**caractérisé par le fait qu'**il comporte entre l'entrée de signal (1) et la base (6) un montage parallèle de deux trajets de signal qui contiennent chacun un interrupteur et un circuit RC, les constantes de temps des deux circuits RC étant différentes l'une de l'autre.

10. Dispositif selon l'une des revendications précédentes,
**caractérisé par le fait que** les interrupteurs sont reliés à chaque fois à la même sortie (18) du premier comparateur (15), un inverseur (25) et un élément temporisateur (24) étant prévus entre la sortie (18) du premier comparateur (15) et l'interrupteur (19) qui a la plus petite constante de temps.

11. Procédé pour l'évaluation de signaux numériques, dans lequel on compare les signaux numériques dans un comparateur (15) à une première valeur de seuil (SU), on fournit à la sortie du comparateur (15) des signaux de niveau bas LOW ou des signaux de niveau haut HIGH et on modifie la valeur de seuil (SU) en fonction de la tension de décalage superposée aux signaux numériques, la tension de décalage étant détectée pendant la présence d'un signal de niveau bas LOW et étant mémorisée dans un dispositif de stockage (4) comme valeur de référence pour le réglage de la valeur de seuil pour le circuit comparateur et une actualisation de la tension de décalage mémorisée s'effectuant pendant la présence de signaux de niveau bas LOW suivants,
**caractérisé par le fait qu'**on règle les valeurs de seuil au moyen d'une source de courant constant (9) et d'un circuit série relié à la source de courant constant (9) et composé de deux résistances (7, 8), la borne, à l'opposé de la source de courant constant (9), du circuit série composé des résistances (7, 8) formant une base (6) et le dispositif de stockage (4) étant relié à cette base (6) par l'intermédiaire d'un amplificateur (5).
